# EUROPEAN PATENT APPLICATION

(11) **EP 1 524 297 A1**
(43) Date of publication of application: **20.04.2005**
(21) Application number: 04106875.0
(22) Date of filing: 22.12.2004
(51) Int. Cl.: C08L 81/06

(54) **Sulfone polymer composition**

(71) Applicant: Solvay Advanced Polymers, L.L.C., Alpharetta, GA 30005-3914 (US)
(72) Inventor: El-Hibri, Mohammad Jamal, GE 30328, Atlanta (US)
(74) Representative: Jacques, Philippe

(57) **Abstract**

The invention relates to a sulfone polymer composition comprising :
- at least one high glass transition temperature sulfone polymer (A)
- at least one miscible polymer (B); and
- at least one immiscible polymer (C).

The invention also relates to a process for manufacturing the sulfone polymer composition and to the articles thereof.

The sulfone polymer composition of the invention possesses notably thermal performances and processability advantages in addition to minor cost with respect to high glass transition temperature sulfone polymers taken done.

## Description

The invention relates to a sulfone polymer composition having a good balance between high temperature performances, melt processability and economic aspects.

High glass transition temperature sulfone polymers are attractive because of their outstanding heat resistance, dimensional stability, good chemical resistance and mechanical integrity up to operating temperature of about 250°C.

Nevertheless, these high glass transition temperature sulfone polymer present several drawbacks, in particular a poor melt processability (due to the extremely high glass transition temperature), and a high cost, due to the expensive monomers required for their synthesis.

These drawbacks and others are remarkably overcome by a sulfone polymer composition comprising:
- at least one high glass transition temperature sulfone polymer (A)
- at least one miscible polymer (B); and
- at least one immiscible polymer (C).

The sulfone polymer composition of the invention possesses advantageously thermal performances and processability advantages in addition to minor cost with respect to high glass transition temperature sulfone polymers.

For the purpose of the invention, the term "polymer" is intended to denote any material consisting essentially of recurring units, and having a molecular weight above 2000.

For the purpose of the invention, the term "high glass transition temperature sulfone polymer" (A) is intended to denote any polymer, at least 50 % wt of the recurring units thereof being recurring units (R1) : 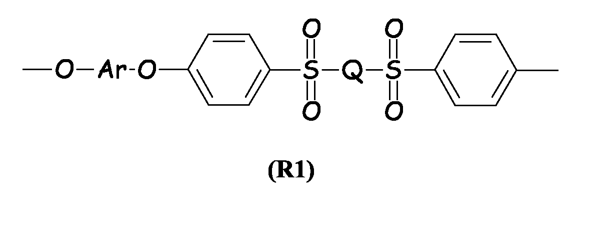 wherein :
- Q is a group chosen among the following structures : 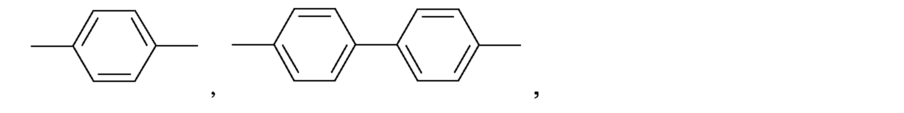 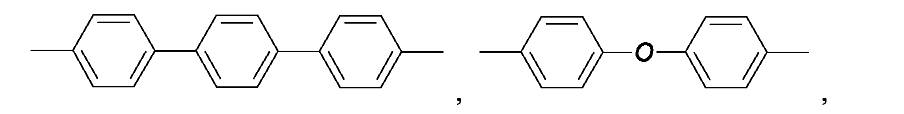 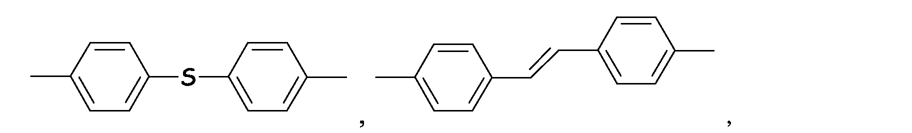 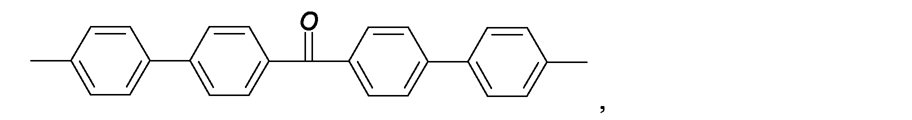 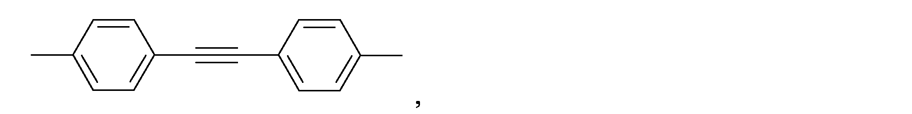 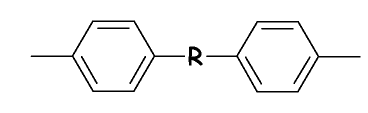 with **R** being : 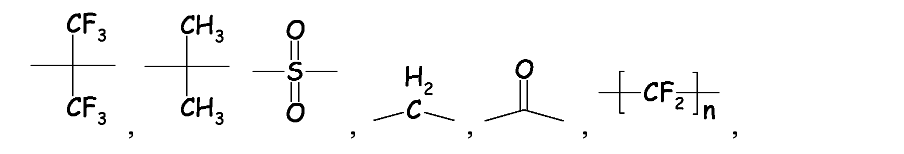 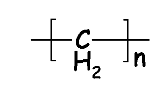 with n = integer from 1 to 6, or an aliphatic divalent group, linear or branched, of up to 6 carbon atoms;
   and mixtures thereof; and
- Ar is a group chosen among the following structures : 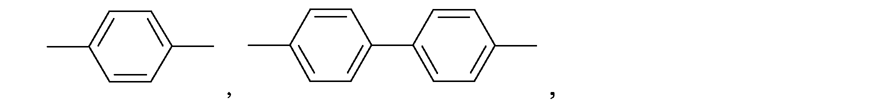 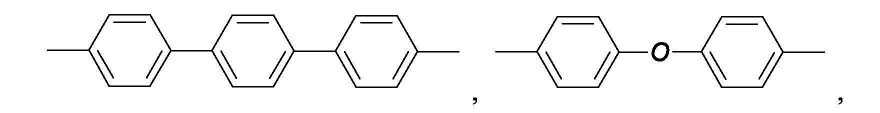 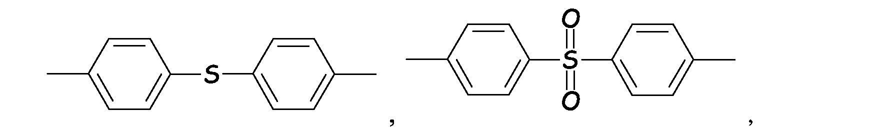 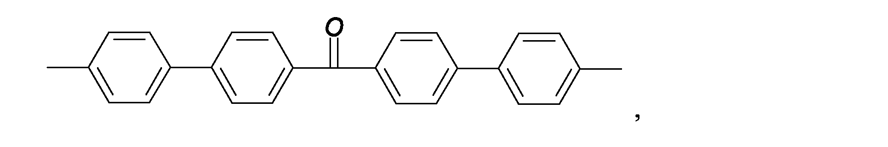 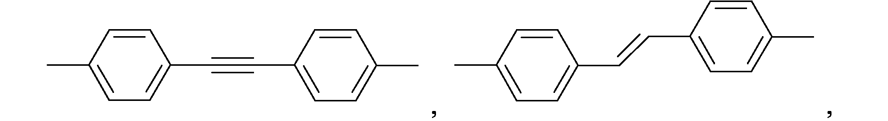 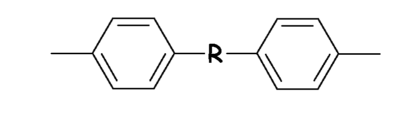 with **R** being : 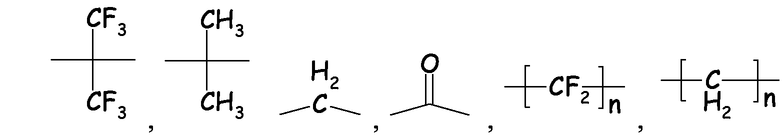 with n = integer from 1 to 6, or an aliphatic divalent group, linear or branched, of up to 6 carbon atoms;
   and mixtures thereof.

Recurring units (R1) are preferably chosen from : 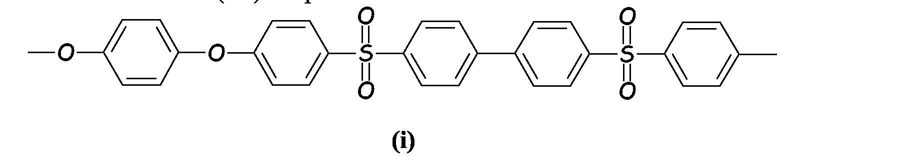 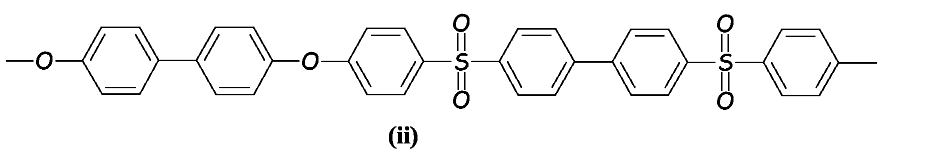 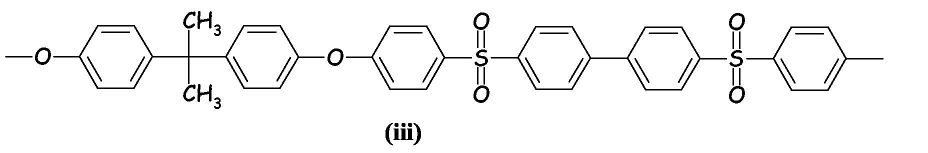 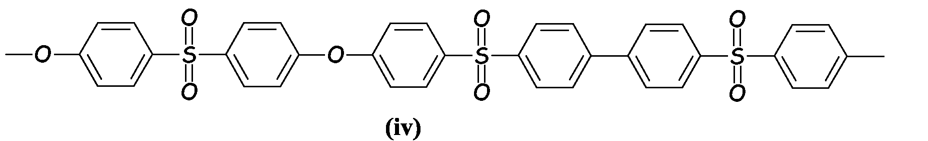 and mixtures therefrom.

More preferably, recurring units (R1) are recurring units (ii).

Polymer (A) may notably be a homopolymer or a copolymer. Should polymer (A) be a copolymer, it may notably be a random, alternating or block copolymer. Although polymer (A) may be a block copolymer in certain particular embodiments of the invention, polymer (A) is generally not a block copolymer.

The high glass temperature sulfone polymer (A) comprises preferably 70 % wt, more preferably 75 % wt of recurring units (R1); still more preferably, it contains no recurring unit other than recurring units (R1).

Excellent results were obtained with high glass transition temperature sulfone polymer (A) consisting of recurring units (ii) (polybiphenyldisulfone, hereinafter).

The term "at least one high transition temperature solfone polymer (A)" means that the polymer composition can comprise one or more than one polymer (A). Should the composition comprise several polymers (A), said polymers (A) are usually miscible, that implies that they display only one glass transition temperature.

The high glass transition temperature sulfone polymer (A) has a glass transition temperature advantageously of at least 230°C, preferably of at least 240°C, more preferably of at least 250°C.

The sulfone polymer composition advantageously comprises at least 20 % wt, preferably at least 40 % wt, more preferably at least 50 % wt of high glass transition temperature sulfone polymer (A), with respect to the total weight of (A), (B) and (C).

The sulfone polymer composition advantageously comprises at most 90 % wt, preferably at most 80 % wt, more preferably at most 75 % wt of high glass transition temperature sulfone polymer (A), with respect to the total weight of (A), (B) and (C).

For the purpose of the invention, the term "miscible polymer" (B) is intended to denote any polymer miscible with the high glass temperature sulfone polymer (A) in the composition according to the invention, i.e. a polymer yielding a single homogeneous phase when mixed with said high glass temperature sulfone polymer (A), showing only one glass transition temperature.

Preferably, the miscible polymer (B) is a miscible sulfone polymer.

For the purpose of the invention, the term "miscible sulfone polymer" is intended to denote any polymer, at least 50 % wt of the recurring units thereof being recurring units (R2) : 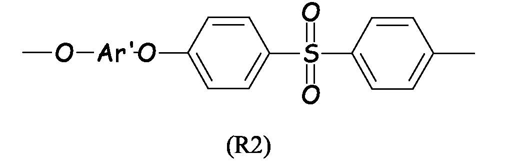 wherein Ar' is a group chosen among the following structures : 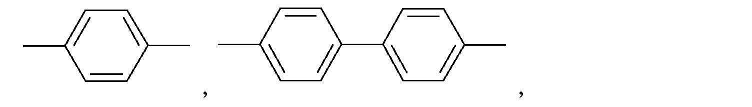 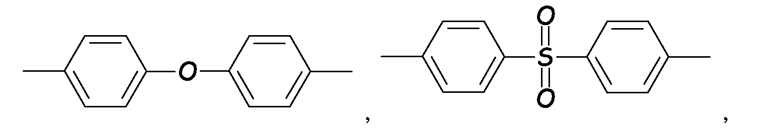 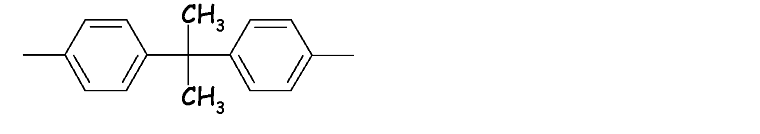 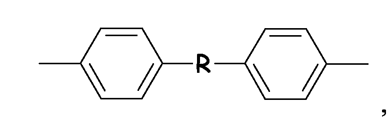 , with R being an aliphatic divalent group of up to 6 carbon atoms, such as methylene, ethylene, isopropylene and the like.

Recurring units (R2) are preferably chosen from : 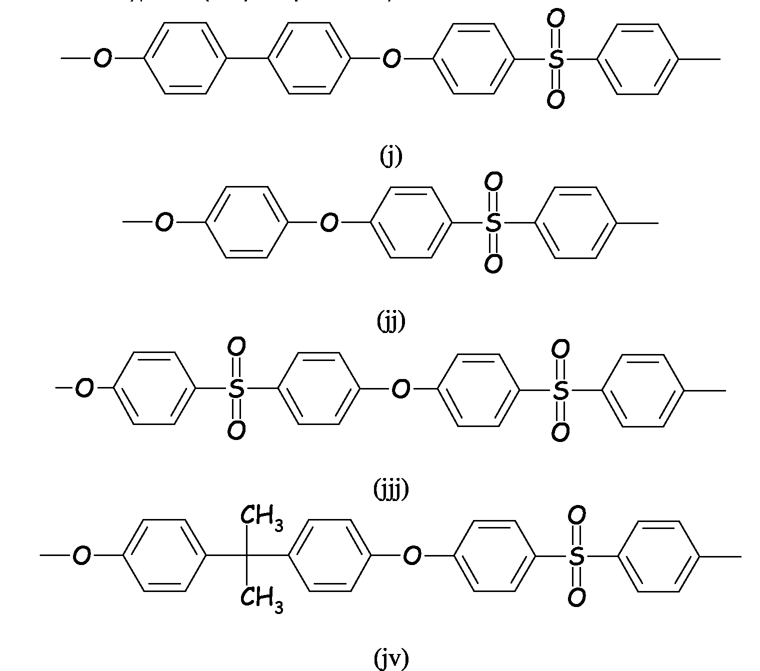 and mixtures therefrom.

More preferably, recurring units (R2) are recurring units (j).

The miscible sulfone polymer comprises generally more than 50 % wt, preferably 70 % wt, more preferably 75 % wt of recurring units (R2). Still more preferably, it contains no recurring unit other than recurring units (R2).

Good results were obtained with miscible sulfone polymer, the recurring units thereof are recurring units (j) (polyphenylsulfone, hereinafter).

Polyphenylsulfone is available as RADEL® R PPSF from Solvay Advanced Polymers, L.L.C..

The sulfone polymer composition advantageously comprises at least 5 % wt, preferably at least 7.5 % wt, more preferably at least 10 % wt of miscible polymer (B), with respect to the total weight of (A), (B) and (C).

The sulfone polymer composition advantageously comprises at most 60 % wt, preferably at most 50 % wt, more preferably at least 40 % wt of miscible polymer (B), with respect to the total weight of (A), (B) and (C).

For the purpose of the invention, the term "immiscible polymer" is intended to denote any polymer immiscible with the high glass transition temperature sulfone polymer (A) in the composition according to the invention, i.e. a polymer yielding a phase-separated mixture when mixed with said high glass transition temperature sulfone polymer (A) or with the mixture of (A) and (B), showing two distinct glass transition temperatures.

One typical feature obtained by adding said immiscible polymer (C) to components (A) and (B) is thus that, since the high glass transition temperature sulfone polymer (A) [and the mixture of (A) and (B)] and the immiscible polymer are phase separated, they retain their separate glass transition temperatures.

The immiscible polymer (C) has a glass transition temperature of advantageously at least 150°C, preferably at least 160°C, more preferably at least 175°C.

The immiscible polymer (C) has a glass transition temperature of advantageously at most 240°C, preferably at most 235°C, more preferably at most 230°C.

Advantageously, the immiscible polymer (C) is selected from the group consisting of immiscible sulfone polymers, polyetherimide polymers, polyetheretherketone polymers (PEEK, herein after), and mixtures thereof.

For the purpose of this invention, the term "immiscible sulfone polymer" is intended to denote any polymer, at least 50 % wt of the recurring units thereof beine recurring units (R3), chosen from : 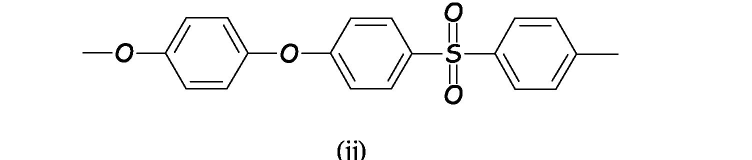 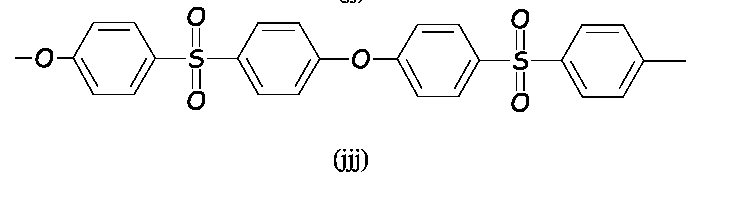 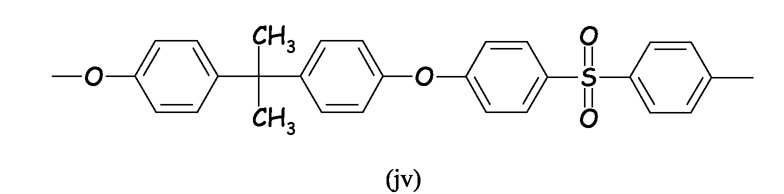 and mixtures therefrom.

Good results were obtained with immiscible sulfone polymer (C) the recurring units of which are recurring units (jj) (polyetherethersulfone, hereinafter), with immiscible sulfone polymer (C) the recurring units of which are recurring units (jjj) and, optionally in addition, recurring units (jj) (polyethersulfone, hereinafter) and with immiscible sulfone polymers (C) the recurring units of which are recurring units (jv) (polysulfone, hereinafter).

Polysulfone is available as UDEL® PSF from Solvay Advanced Polymers, L.L.C.. Polyethersulfone is available as RADEL® A PES from Solvay Advanced Polymers, L.L.C..

The immiscible sulfone polymer comprises preferably 70 % wt, more preferably 75 % wt of recurring units (R3). Still more preferably, it contains no recurring unit other than recurring units (R3).

For the purpose of the invention, the term "polyetherimide polymer" is intended to denote any polymer, at least 50 % wt of the recurring units thereof being recurring units (R4), comprising two imide groups as such (R4-A) and/or in their corresponding amic acid forms [(R4-B) and (R4-C)] : 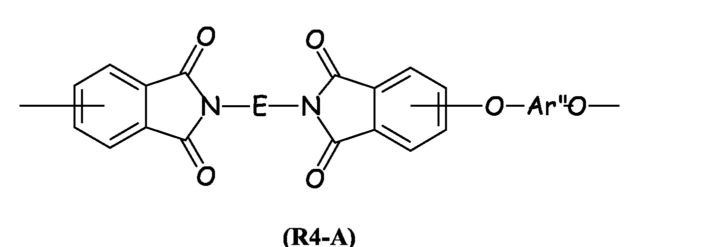 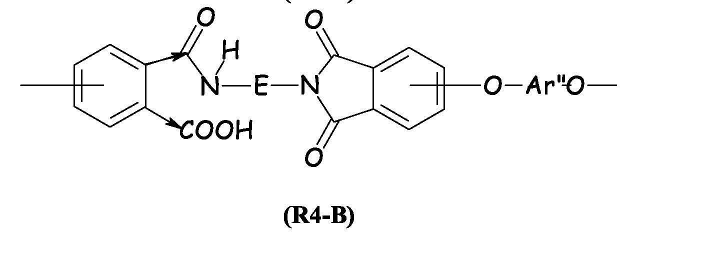 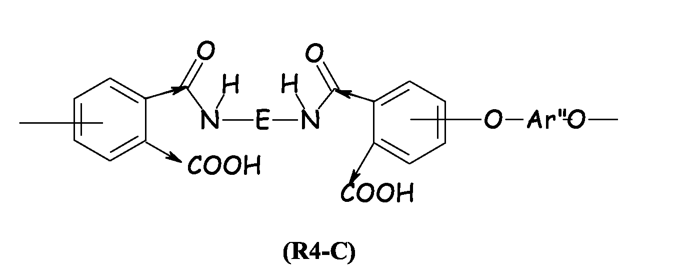 wherein :
- the → denotes isomerism so that in any recurring unit the groups to which the arrows point may exist as shown or in an interchanged position;
- E is typically : 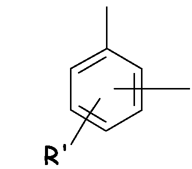 with the linking groups being in ortho, meta or para position and R' being a hydrogen atom or an alkyl radical comprising from 1 to 6 carbon atoms ; 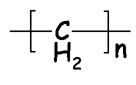 with n = integer from 1 to 6 ; 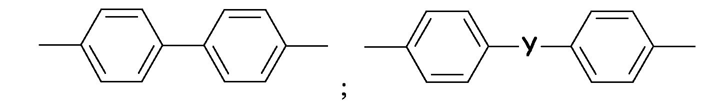 with **Y** being : 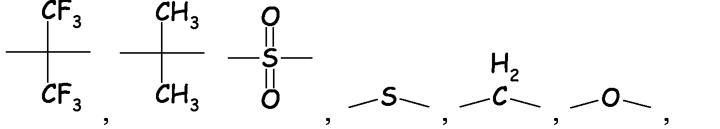 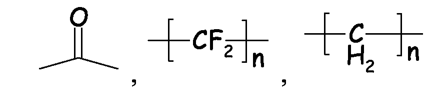 with n = integer from 1 to 6 ;
- Ar" is typically : 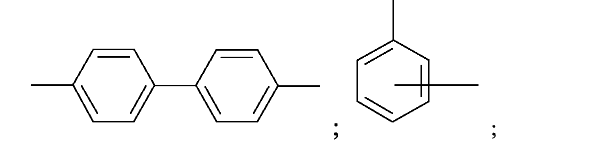 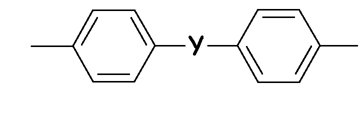 with **Y** being : 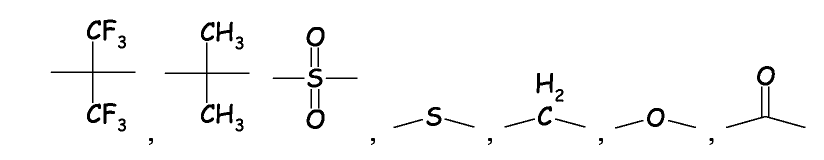 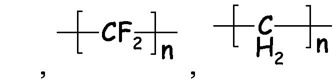 with n = integer from 1 to 6.

Recurring units (R4) are preferably recurring units (k), in imide (k-A) and/or in amic acid form [(k-B) and (k-C)] : 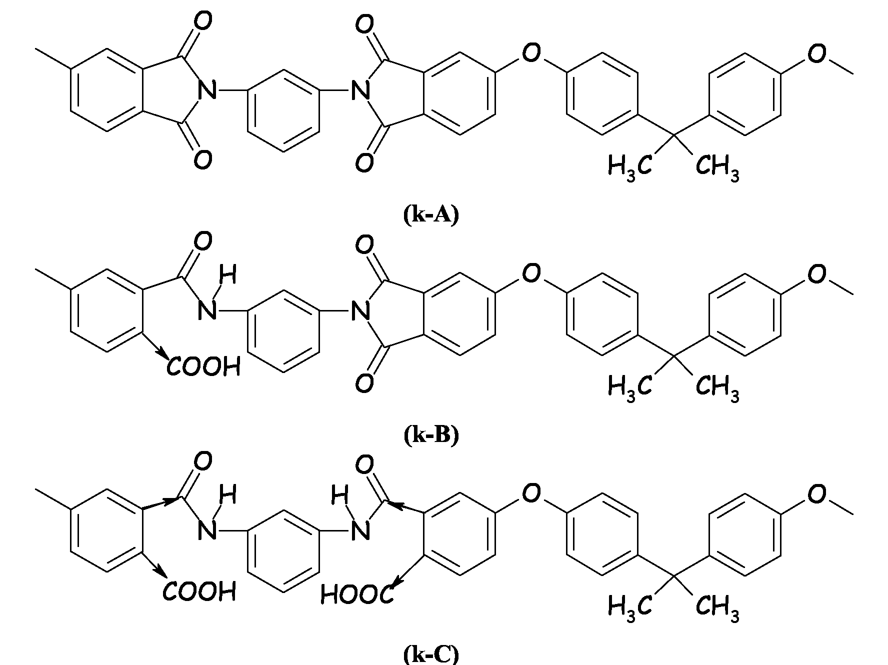 wherein in formulae (k-B) and (k-C) the → denotes isomerism so that in any recurring unit the groups to which the arrows point may exist as shown or in an interchanged position.

The polyetherimide polymer comprises advantageously at least 50 % wt, preferably 70 % wt, more preferably 75 % wt of recurring units (R4), still more preferably, it contains no recurring unit other than recurring units (R4).

Good results have been obtained with polyetherimide polymer consisting of recurring units (k). Polymers available as ULTEM® PEI from GE Plastics comply with this criterion.

For the purpose of this invention, the term "polyetherether ketone polymer" is intended to denote any polymer, at least 50 % wt of the recurring units thereof being recurring units (R5) :

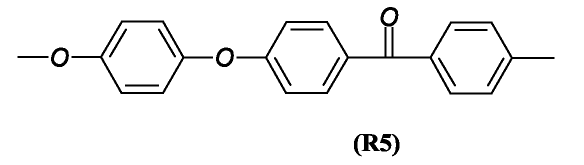

The polyetheretherketone polymer comprises advantageously at least 50 % wt, preferably 70 % wt, more preferably 75 % wt of recurring units (R5), still more preferably, it contains no recurring unit other than recurring units (R5).

Polymers commercially available as VICTREX® PEEK comply with this criterion.

The sulfone polymer composition advantageously comprises at least 5 % wt, preferably at least 7.5 % wt, more preferably at least 10 % wt of immiscible polymer (C), with respect to the total weight of (A), (B) and (C).

The sulfone polymer composition advantageously comprises at most 60 % wt, preferably at most 50 % wt, more preferably at least 40 % wt of immiscible polymer (C), with respect to the total weight of (A), (B) and (C).

In a first preferred embodiment of the invention, the immiscible polymer (C) is an immiscible sulfone polymer selected from the group consisting of polysulfone, polyethersulfone, polyetherethersulfone and mixtures thereof. More preferably, the component (C) of the first embodiment of the invention is chosen among the group consisting of polyethersulfone, polysulfone and mixtures thereof.

In a second preferred embodiment of the invention, the immiscible polymer (C) is a polyetherimide polymer. More preferably, the component (C) of the first embodiment of the invention is a polyetherimide polymer consisting of recurring units (k).

Optionally, the sulfone polymer composition can further comprise lubricating agents, heat stabilizer, anti-static agents, extenders, reinforcing agents, organic and/or inorganic pigments like TiO₂, carbon black, acid scavengers, such as MgO, stabilizers, i.e., metal oxides such as zinc oxide, antioxidants, flame retardants, smoke-suppressing agents.

The sulfone polymer composition optionally comprises at least one filler chosen from reinforcing fillers, structural fibers and mixtures thereof Structural fibers may include glass fiber, carbon or graphite fibers, and fibers formed of silicon carbide, alumina, titania, boron and the like, and may include mixtures comprising two or more such fibers. Reinforcing fillers which can also be used in sulfone polymer composition include notably pigments, flake, spherical and fibrous particulate filler reinforcements and nucleating agents such as talc, mica, titanium dioxide, potassium titanate, silica, kaolin, chalk, alumina, mineral fillers, and the like. The reinforcing fillers and structural fibers can be used alone or in any combination.

Another aspect of the present invention concerns a process for manufacturing the sulfone polymer composition as above described, which comprises mixing the at least one high glass transition temperature sulfone polymer (A), the at least one miscible polymer (B), and the at least one immiscible polymer (C).

Advantageously, the process comprises mixing by dry blending and/or melt compounding the high glass transition temperature sulfone polymer (A), the miscible polymer (B), and the immiscible polymer (C).

Preferably, the high glass transition temperature sulfone polymer (A), the miscible polymer (B), and the immiscible polymer (C) are mixed by melt compounding.

Advantageously, the high glass transition temperature sulfone polymer (A), the miscible polymer (B), and the immiscible polymer (C) are melt compounded in continuous or batch devices. Such devices are well-known to those skilled in the art.

Examples of suitable continuous devices to melt compound the sulfone polymer composition of the invention are notably screw extruders. Thus, the high glass transition temperature sulfone polymer (A), the miscible polymer (B), and the immiscible polymer (C) and optionally, other ingredients, are advantageously fed in powder or granular form in an extruder and the sulfone polymer composition is advantageously extruded into strands and the strands are advantageously chopped into pellets.

Optionally, fillers, lubricating agents, heat stabilizer, anti-static agents, extenders, reinforcing agents, organic and/or inorganic pigments like TiO₂, carbon black, acid scavengers, such as MgO, flame-retardants, smoke-suppressing agents may be added to the composition during the compounding step.

Preferably, the high glass transition temperature sulfone polymer (A), the miscible polymer (B), and the immiscible polymer (C) are melt compounded in a twin-screw extruder.

The sulfone polymer composition can be processed following standard methods for injection molding, extrusion, thermoforming, machining, and blow molding. Solution-based processing for coatings and membranes is also possible. Finished articles comprising the sulfone polymer composition can undergo standard post-fabrication operations such as ultrasonic welding, adhesive bonding, and laser marking as well as heat staking, threading, and machining.

Still an object of the invention is an article comprising the sulfone polymer composition as above described.

Advantageously the article is an injection molded article, an extrusion molded article, a shaped article, a coated article or a casted article.

Non-limitative examples of articles are shaped article, electronic components (such as printed circuit boards, electrical plug-in connectors, bobbins for relays and solenoids), pipes, fittings, housings, films, membranes, coatings.

The articles according to the invention can be fabricated by processing the sulfone polymer composition as above described following standard methods.

The present invention is described in greater detail below by referring to the Examples; however, the present invention is not limited to these examples.

### Raw materials :

The polybiphenyldisulfone obtained from the polycondensation of 4,4'-bis-(4-chlorophenyl sulfonyl)biphenyl and 4,4'-dihydroxydiphenyl, has been used. The table 1 here below summarizes main properties of two materials used in preparing the compositions :

**Table 1 -**

| **Properties of the polybiphenyldisulfone polymers** | | | |
|---|---|---|---|
| | | Polybiphenyldisulfone Batch #A | Polybiphenyldisulfone Batch # B |
| GPC measurements | Mₙ (Dalton) | 17100 | 17670 |
| | M_{w} (Dalton) | 41970 | 47200 |
| | M_{w}/Mₙ | 2.45 | 2.67 |
| DSC measurements | T_{g} (°C) | 265.6 | 264.7 |
| Melt flow index^{(†)} | MFI [400°C/5 kg] (g/10 min) | 30.3 | 28.5 |
| Mechanical Properties | Tensile Modulus^{(◊)} (Kpsi) | 346.4 | 312 |
| | Elongation at yield^{(◊)} (%) | 8.6 | 8.5 |
| | Elongation at break^{(◊)} (%) | 10.6 | 18.0 |
| | Notched Izod ^{(‡)} (ft-lb/in) | 2.3 ^{(*)} | 3.1 ^{(*)} |
| | HDT [annealed] ^{(§)}(°C) | 256.7 | n.d. |

| | | | |
|---|---|---|---|
| (†) Melt flow index measured according to ASTM D 1238, at a temperature of 400°C, under a load of 5 kg. | | | |
| (◊) Tensile properties measured according to ASTM D 638. | | | |
| (‡) Notched Izod has been measured at 25°C according to ASTM D256 (test method A). | | | |
| (§) Test parts were annealed at 250°C for 1 hour prior to HDT testing. Heat Deflection Temperature (HDT) has been measured according to ASTM D648. | | | |
| (*) Izod break type : Complete. | | | |

RADEL® R-5800 NT polyphenylsulfone commercially available from Solvay Advanced Polymers, L.L.C., a sulfone polymer obtained from the polycondensation of a 4,4'-dihalodiphenylsulfone and 4,4'-dihydroxydiphenyl, has been used. Table 2 here below summarizes main properties of the material used in preparing the compositions :

**Table 2 -**

| **Properties of the polyphenylsulfone** | | |
|---|---|---|
| | | RADEL® R-5800 NT polyphenylsulfone |
| DSC measurements | T_{g} (°C) | 219.4 |
| Melt flow index^{(†)} | MFI [400°C/5 kg] (g/10 min) | 46.4 |
| Mechanical Properties | Tensile Modulus^{(◊)} (Kpsi) | 414 |
| | Elongation at yield^{(◊)} (%) | 7.3 |
| | Elongation at break^{(◊)} (%) | 110 |
| | Notched Izod ^{(‡)} (ft-lb/in) | 12.8(†) |
| | HDT [annealed] ^{(§)}(°C) | 210 |

| | | |
|---|---|---|
| (†) Melt flow index measured according to ASTM D 1238, at a temperature of 400°C, under a load of 5 kg. | | |
| (◊) Tensile properties measured according to ASTM D 638. | | |
| (‡) Notched Izod has been measured at 25°C according to ASTM D256 (test method A). | | |
| (§) Test parts were annealed at 200°C for 1 hour prior to HDT testing. Heat Deflection Temperature (HDT) has been measured according to ASTM D648. (†) Izod break type : Partial | | |

RADEL® A-301 NT polyethersulfone commercially available from Solvay Advanced Polymers, L.L.C., a polyethersulfone polymer obtained from the polycondensation of a 4,4'-dihalodiphenylsulfone and
4,4'-dihydroxydiphenylsulfone, UDEL® P-1700 NT polysulfone, a polysulfone obtained from the polycondensation of a 4,4'-dihalodiphenylsulfone and Bisphenol-A commercially available from Solvay Advanced Polymers, L.L.C., and ULTEM® 1000 polyetherimide commercially available from GE Plastics have been used. Table 3 here below summarizes main properties of the materials used in preparing the compositions :

**Table 3 -**

| **Properties of the immiscible polymers** | | | | |
|---|---|---|---|---|
| | | RADEL® A-301 NT polyethersulfone | UDEL® P-1700 NT polysulfone | ULTEM® 1000 polyetherimide |
| DSC measurements | T_{g}(°C) | 224.5 | 188.8 | 216.3 |
| Melt flow index^{(†)} | MFI [400°C/5 kg] (g/10 min) | 103.1 | 47.3 | 51.7 |
| Mechanical Properties | Tensile Modulus^{(◊)} (Kpsi) | 440 | 441 | 579 |
| | Elongation at yield^{(◊)} (%) | 6.3 | 5.3 | 6.7 |
| | Elongation at break^{(◊)} (%) | 89 | 110 | 92 |
| | Notched Izod ^{(‡)} (ft-lb/in) | 1.4 | 1.2 | 1.1 |
| | HDT [annealed] ^{(§)}(°C) | 212.7 | 179.9 | 207.2 |

| | | | | |
|---|---|---|---|---|
| (†) Melt flow index measured according to ASTM D 1238, at a temperature of 400°C, under a load of 5 kg. | | | | |
| (‡) Notched Izod has been measured at 25°C according to ASTM D256 (test method A). | | | | |
| (§) Test parts were annealed at 200°C for 1 hour prior to HDT testing. Heat Deflection Temperature (HDT) has been measured according to ASTM D648. | | | | |
| (◊) Tensile properties measured according to ASTM D 638. | | | | |

### Compounding procedure :

The compositions were melt compounded using a 25 mm diameter twin screw double vented Berstorff extruder having an L/D ratio of 33/1 according to the conditions profile shown in Table 4. The first vent port was open to the atmosphere; the second was connected to a vacuum pump. The extruder was fitted with a double strand die. The polymer extrudate was pelletized after passing through a water trough for cooling. All blends were extruded and pelletized without incident at the throughput rates indicated in Table 4.

**Table 4 -**

| **Compounding conditions** | |
|---|---|
| Barrel temperature (°C) | |
| Throat | No heat |
| Zone 1 | 315 |
| Zone 2 | 335 |
| Zone 3 | 335 |
| Zone 4 | 340 |
| Zone 5 | 335 |
| Zone 6 | 340 |
| Zone 7 | 330 |
| Die | 345 |
| | |
| Melt temperature | 390-410 °C |
| Screw Speed | 200 rpm |
| Throughput rate | 14 lb/hr |
| Vent 1 (at zone 1) | Open to atmosphere |
| Vent 2 (at zone 6) | 30 in Hg Vacuum |

### Injection molding procedure

Following compounding, the resin pellets from the various resins and compositions were dried for about 16 hrs in a 149°C (300 F) desiccated hot air oven with a due point of -37.2°C (-35 F). Parts were then injection molded into 1/8" thick ASTM tensile and flexural test specimens using a Wasp Mini-Jector benchtop injection molding machine equipped with a 3/4" general purpose screw and a 20 L/D. Injection molding machine temperature settings were 395°C, 400°C and 405°C for the rear, front and nozzle sections respectively. An injection pressure of 1100 psi was used along with a mold temperature of 85°C (185 F) and a screw speed of 60 RPM.

### Mechanical Properties determinations

A standard flexural bar 5" x ½" x ⅛" was used for ASTM D648 HDT determinations and for ASTM D256 Notched Izod measurements (test method A). A type I ASTM tensile bar, 4.5" in gage length × ½" wide ×⅛" thick was used for ASTM D638 Tensile properties determinations.

### Examples 1 to 3

Ternary blends of a high glass transition temperature sulfone polymer, a miscible sulfone polymer and an immiscible polymer were prepared by melt compounding as specified here above. Details of composition and characterization of the blends are summarized in Table 5 here below.

**Table 5 -**

| **Composition and characterization of ternary blends** | | | | |
|---|---|---|---|---|
| | | **Example 1** | **Example 2** | **Example 3** |
| Composition | Polybiphenyldisulfone (% wt) | 55 (Batch #B) | 55 (Batch #B) | 55 (Batch #A) |
| | RADEL® R-5800 NT polyphenylsulfone (% wt) | 22.5 | 22.5 | 22.5 |
| | RADEL® A-301 NT polyethersulfone | 22.5 | | |
| | UDEL® P-1700 NT 11 polysulfone | | 22.5 | |
| | ULTEM® 1000 polyetherimide | | | 22.5 |
| DSC measurements | T_{g} (°C) | 230.5 | 189.4 | 219.7 |
| | 2nd T_{g} (°C) | 245.7 | 246.2 | 242.4 |
| Melt flow index^{(†)} | MFI [400°C/5 kg] (g/10 min) | 42.9 | 38.2 | 44.3 |
| Mechanical Properties | Tensile Modulus^{(◊)} (Kpsi) | 356 | 334 | 363 |
| | Elongation at yield^{(◊)} (%) | 7.9 | 7.7 | 7.7 |
| | Elongation at break^{(◊)}(%) | 38 | 58 | 47 |
| | Notched Izod^{(‡)} (ft-lb/in) | 2.6 | 2.6 | 1.9 |
| | HDT [annealed] ^{(§)} (°C) | 235.2 | 234.4 | 231.8 |
| Transparency | (comments) | Opalescent | Opalescent | Hazy |

| | | | | |
|---|---|---|---|---|
| (†) Melt flow index measured according to ASTM D 1238, at a temperature of 400°C, under a load of 5 kg. | | | | |
| (‡) Notched Izod has been measured at 25°C according to ASTM D256 (test method A). | | | | |
| (§) Test parts were annealed at 230°C for 1 hour prior to HDT testing. Heat Deflection Temperature (HDT) has been measured according to ASTM D648. | | | | |
| (◊) Tensile properties measured according to ASTM D 638. | | | | |

## Claims

1. ― Sulfone polymer composition comprising :
- at least one high glass transition temperature sulfone polymer (A);
- at least one miscible polymer (B); and
- at least one immiscible polymer (C).
where at least 50 % wt of the recurring units of polymer (A) are recurring units (R1) : 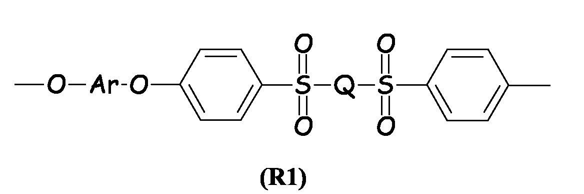 wherein :
- Q is a group chosen among the following structures : 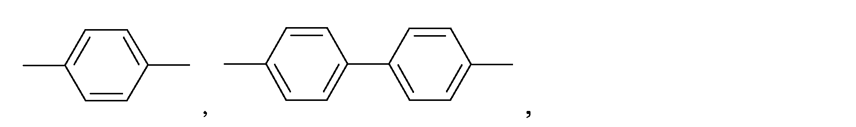 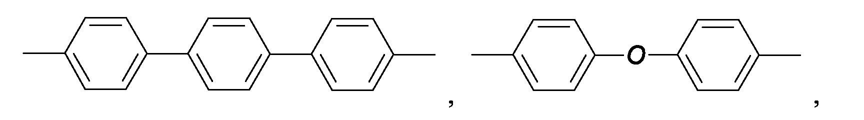 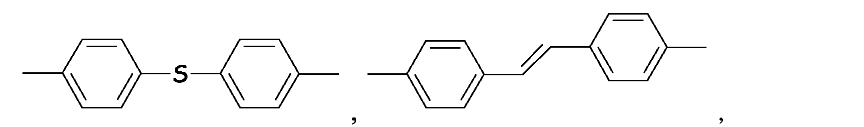 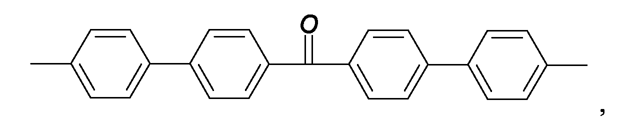 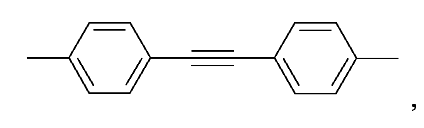 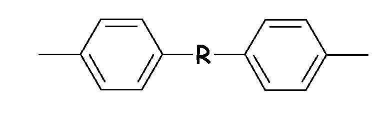 with **R** being : 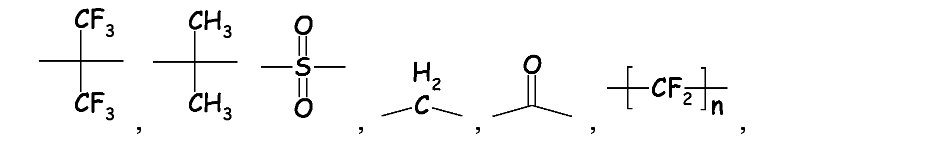 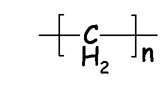 with n = integer from 1 to 6, or an aliphatic divalent group, linear or branched, of up to 6 carbon atoms;
and mixtures thereof; and
- Ar is a group chosen among the following structures : 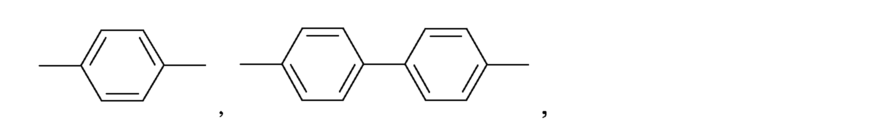 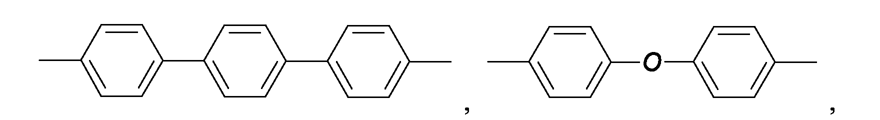 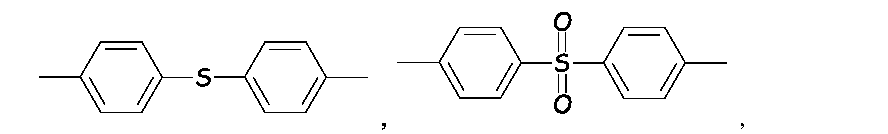 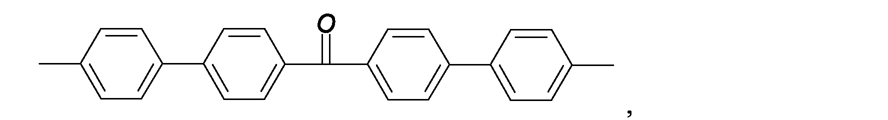 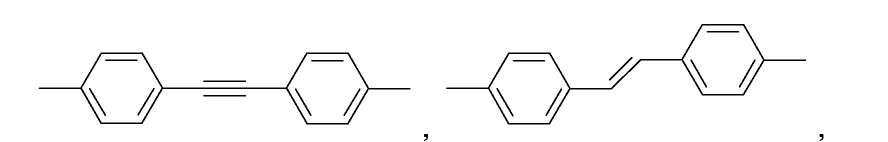 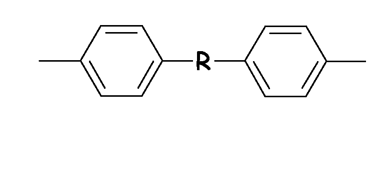 with **R** being : 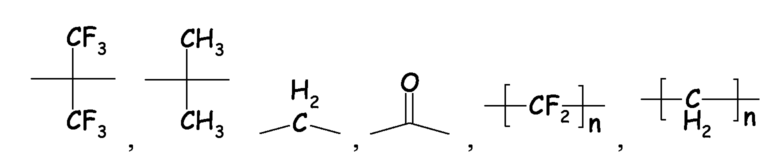 with n = integer from 1 to 6, or an aliphatic divalent group, linear or branched, of up to 6 carbon atoms;
and mixtures thereof.

2. ― Composition according to Claim 1, **characterized in that** recurring units (R1) are recurring units (ii) :

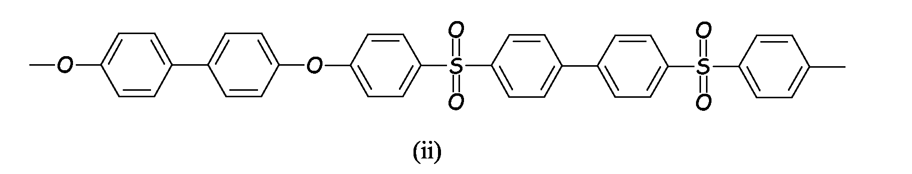

3. ― Composition according to Claim 1 or 2, **characterized in that** polymer (A) contains no recurring unit other than recurring units (R1).

4. ― Composition according to anyone of the preceding Claims, **characterized in that** polymer (B) is a miscible sulfone polymer, at least 50 % wt of the recurring units thereof being recurring units (R2) : 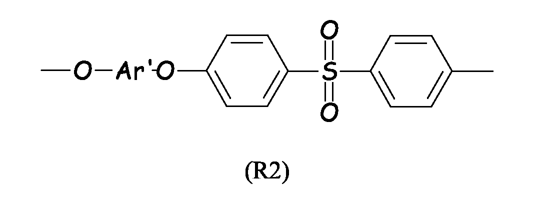 wherein Ar' is a group chosen among the following structures : 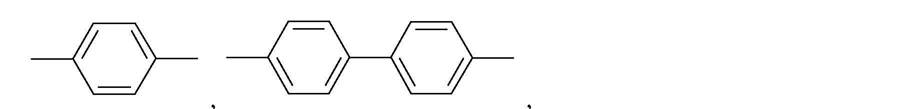 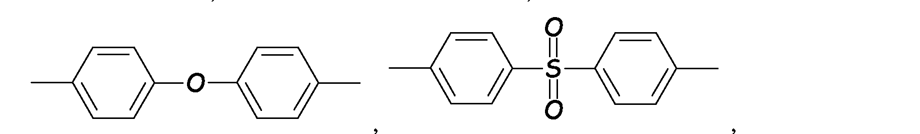 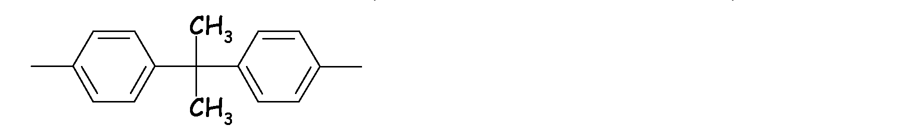 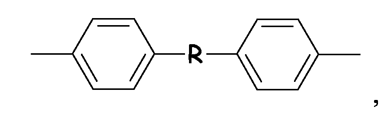 with R being an aliphatic divalent group of up to 6 carbon atoms, such as methylene, ethylene, isopropylene and the like.

5. ― Composition according to Claim 4, **characterized in that** at least 50 % wt of the recurring units of the polymer (B) are recurring units (j) :

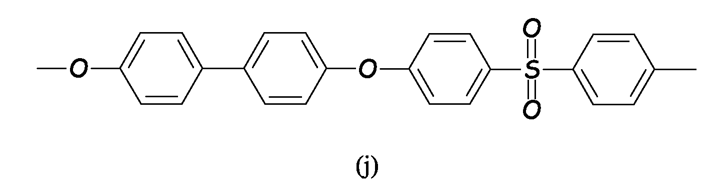

6. ― Composition according to anyone of preceding Claims, **characterized in that** the immiscible polymer (C) is selected from the group consisting of immiscible sulfone polymers, polyetherimide polymers, polyetheretherketone polymers, and mixtures thereof.

7. ― Composition according to Claim 6, **characterized in that** the immiscible polymer (C) is an immiscible sulfone polymer selected from the group consisting of polysulfone, polyethersulfone, polyetherethersulfone and mixtures thereof.

8. ― Composition according to Claim 6, **characterized in that** the immiscible polymer (C) is a polyetherimide polymer.

9. Composition according to Claim 6 or 8, **characterized in that** the immiscible polymer (C) is a polyetherimide polymer, at least 50 % wt of the recurring units thereof being recurring unit (k), in imide (k-A) and/or amic acid form [(k-B) and (k-C)] : 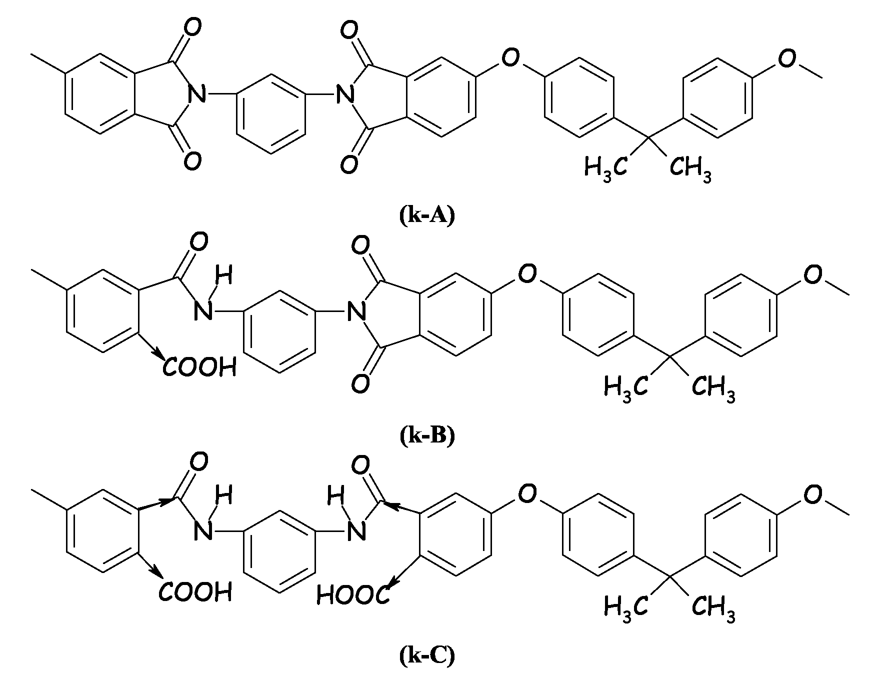 wherein in formulae (k-B) and (k-C) the → denotes isomerism so that in any recurring unit the groups to which the arrows point may exist as shown or in an interchanged position.

10. Process for manufacturing the sulfone polymer composition according to anyone of Claims 1 to 9, which comprises mixing the at least one high glass transition temperature sulfone polymer (A), the at least one miscible polymer (B), and the at least one immiscible polymer (C).

11. Article comprising the sulfone polymer composition according to anyone of Claims 1 to 9.
